# EUROPEAN PATENT APPLICATION

(11) **EP 4 765 483 A1**
(43) Date of publication of application: **24.06.2026**
(21) Application number: 25226296.9
(22) Date of filing: 22.12.2025
(51) Int. Cl.: H01Q 1/27

(54) **ANTENNA STRUCTURE WITH IN-LINE HARMONIC FILTER FOR HEARING INSTRUMENTS**

(30) Priority: 23.12.2024 US 202463738265 P; 18.12.2025 US 202519425847
(71) Applicant: Starkey Laboratories, Inc., Eden Prairie, MN 55344 (US)
(72) Inventor: CHANG, Arkajyoti, Eden Prairie, MN, 55344 (US); HAUBRICH, Gregory John, Eden Prairie, MN, 55344 (US)
(74) Representative: Vossius & Partner Patentanwälte Rechtsanwälte mbB

(57) **Abstract**

An antenna for a hearing instrument comprises a first antenna segment; and a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

## Description

This application claims the benefit of U.S. Provisional Patent Application 63/738,265, filed December 23, 2024 and U.S. Non-Provisional Patent Application 19/425,847, filed on December 18, 2025, the entire content of which are incorporated by reference.

### TECHNICAL FIELD

This disclosure relates to antennas for hearing instruments.

### BACKGROUND

Wearable devices are devices designed to be worn on, in, or near a user's body. Example types of wearable devices may include hearing instruments, smart watches, on-body biometric sensors, media players, augmented or virtual reality headwear, and so on. Hearing instruments are wearable devices designed to be worn on, in, or near one or more of a user's ears. Common types of hearing instruments include hearing assistance devices (e.g., "hearing aids"), earbuds, headphones, hearables, cochlear implants, and so on. In some examples, a hearing instrument may be implanted or integrated into a user. Some hearing instruments include additional features beyond sound-amplification. For example, some modern hearing instruments include advanced audio processing for improved device functionality, controlling and programming the devices, and beamforming, and some can even communicate wirelessly with external devices including other hearing instruments (e.g., for streaming media).

### SUMMARY

This disclosure describes antenna designs for hearing instruments. As described in this disclosure, a first antenna segment of an antenna for a hearing instrument includes an in-line filter that is configured to attenuate one or more harmonic frequencies from an electrical current passing between a feed point and a second antenna segment via the first antenna segment. In some examples, the first antenna segment includes a first branch and a second branch separated by a first conductor opening, a third branch and a fourth branch separated by a second conductor opening, and a neck that connects the first branch and the third branch. A filter element of the one or more filter elements may be disposed on the first branch, a filter element of the one or more filter elements may be disposed on the third branch, a filter element of the one or more filter elements may bridge the first conductor opening, and/or a filter element of the one or more filter elements may bridge the second conductor opening.

In one example, this disclosure describes an antenna for a hearing instrument, the antenna comprising: a first antenna segment; and a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

In another example, this disclosure describes a hearing instrument comprising an antenna that comprises: a first antenna segment; and a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

The details of one or more aspects of the disclosure are set forth in the accompanying drawings and the description below. Other features, objects, and advantages of the features and techniques described in this disclosure will be apparent from the description, drawings, and claims.

### BRIEF DESCRIPTION OF DRAWINGS

FIG. 1 is a conceptual diagram illustrating an example system that includes one or more hearing instruments, in accordance with one or more aspects of this disclosure.
FIG. 2 is a block diagram illustrating example components of a hearing instrument, in accordance with one or more aspects of this disclosure.
FIG. 3 is a schematic diagram illustrating an example baseline antenna, in accordance with one or more aspects of this disclosure.
FIG. 4 is a schematic diagram illustrating an example antenna with an in-line filter, in accordance with one or more aspects of this disclosure.
FIG. 5 is a schematic diagram illustrating example details of an antenna segment that provides an in-line filter, in accordance with one or more aspects of this disclosure.

### DETAILED DESCRIPTION

Wireless communication links are becoming an increasingly significant aspect of wearable devices, such as hearing instruments. Although much of this disclosure describes hearing instruments, the antennas and antenna designs of this disclosure may be used in other types of wearable devices that include wireless capabilities. A hearing instrument may use wireless communication links to communicate with other hearing instruments or with other types of devices, such as mobile phones or hearing instrument accessories. Such communication may serve a wide variety of purposes, such as streaming media data and sending sensor data.

Because excess radio frequency (RF) emissions can interfere with other electronic devices and potentially cause health and safety problems, electronic devices are required to comply with governmental regulations regarding RF emissions. The presence of harmonics in an electrical alternating current within an antenna may cause the antenna to generate excess RF emissions and interference with other electronic devices. A harmonic of an alternating current is a component of an electrical waveform that operates at a frequency that is an integer multiple of a fundamental frequency. Harmonics can also distort transmitted signals and can lead to efficiency loss.

Hearing instruments often use a fundamental frequency in a range of 2.4 - 2.4835 gigahertz (GHz). In other words, a transceiver may modulate a 2.4-2.4835 GHz electrical signal to encode information into the electrical signal. Harmonics of a transmitter that uses fundamental frequencies in a range of 2.4 - 2.4835 GHz (e.g., a 2.4 GHz transmitter) have been a chronic challenge when designing electronic devices, such as hearing instruments. The issue of harmonics is exacerbated in hearing instruments that include RF front-end (RFFE) modules that amplify a transmit power fed into an antenna. For example, an RFFE module of a hearing instrument may increase a transmit power fed into an antenna by +12 decibels (dB) relative to previous hearing instrument designs. However, including such an RFFE module may increase harmonics by +20 dB or more relative to the previous hearing instrument designs. The presence or absence of harmonics in RF transmissions emitted by an antenna of a hearing instrument may occur due to factors other than the design of the antenna itself. As a result, the presence or absence of harmonics in the RF transmissions emitted by the antenna of the hearing instrument may not be known until late in a process of designing the hearing instrument. The antenna or printed circuit board (PCB) may therefore need to be redesigned late in the process of designing the hearing instrument, such as after governmental review of the RF emissions of the hearing instrument. For example, a low pass filter or additional passive components may need to be added to the PCB to suppress one or more harmonics. Redesigning an antenna or altering a PCB design late in the process of designing the hearing instrument may be expensive and may prolong a time-to-market of the hearing instrument.

Existing approaches for lowering harmonics emissions of RF transmitters in hearing instruments have included surface acoustic wave (SAW) band-pass filters and low-temperature co-fired ceramic (LTCC) low-pass filters. While these filters work well in circuits with large and effective ground-planes, and when matched into their designed input/output impedances of 50 ohms, and/or 100 ohms, their harmonic filtering performance is significantly degraded when working into the high voltage standing wave ratio (VSWR) presented at the antenna feed-point when the hearing instrument is operated in air (vs. on-head/in-situ where it is designed to be impedance matching). Furthermore, the filters occupy valuable space on printed circuit boards (PCBs) of hearing instruments and may increase overall costs. Moreover, LTCC filters are included in main flex circuits (i.e., main flexible circuit boards) as opposed to antenna flexes (i.e., flexible conductors for radiation of RF signals). Modifications to main flex circuits can be more difficult to make as compared to modifications to antenna flexes. Thus, if modifications are needed to attenuate one or more harmonics, it may be easier and may be less complex to make such modifications to an antenna flex as opposed to a main flex circuit.

This disclosure describes antenna designs that may significantly reduce the magnitudes of radiated emissions at one or more harmonics of a fundamental frequency (e.g., a 2.4 GHz fundamental frequency) while not significantly impacting the power output at the fundamental frequency. As described herein, a hearing instrument may include an antenna having an integrated, in-line filter. The integrated filter attenuates one or more harmonics of a fundamental frequency in an electrical signal flowing within the antenna. The integrated filter may operate on its own or in conjunction with conventional filters. The use of the integrated filter may enable the hearing instrument to comply with regulatory requirements for RF emissions, even when the hearing instrument is using an RFFE module. Furthermore, use of the integrated filter may provide a level of design margin that may minimize the need for design changes late in a process of designing the hearing instrument.

In one example, this disclosure describes an antenna for a hearing instrument. The antenna comprises at least a first antenna segment and a second antenna segment. The first antenna segment is between a feed point of the antenna and the second antenna segment. The first antenna segment provides an in-line filter that is configured to attenuate one or more harmonic frequencies from an electrical current passing between the feed point and the second antenna segment via the first antenna segment. The inclusion of the in-line filter in the first antenna segment may reduce spurious emissions when the antenna is radiating, thereby potentially allowing the antenna to complete radio regulatory certifications. Because the in-line filter is included in a segment of the antenna (e.g., as part of an antenna flex and not a main flex circuit), the overall physical space involved with the antenna and associated components may be reduced relative to hearing instruments that use SAW or LTCC filters. Moreover, it may be less complicated and/or faster to make modifications to such an antenna (e.g., a 2-layer antenna flex) to attenuate one or more harmonics than to a main circuit flex (e.g., a 4-layer main circuit flex).

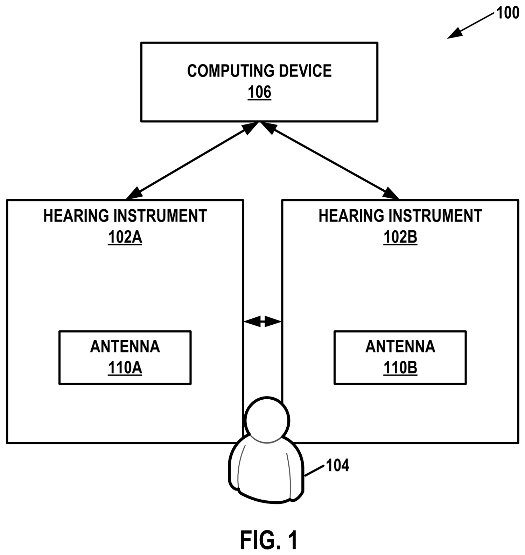

FIG. 1 is a conceptual diagram illustrating an example system 100 that includes hearing instruments 102A, 102B, in accordance with one or more aspects of this disclosure. This disclosure may refer to hearing instruments 102A and 102B collectively, as "hearing instruments 102." A user 104 may wear hearing instruments 102. In some instances, user 104 may wear a single hearing instrument. In other instances, the user may wear two hearing instruments, with one hearing instrument for each ear of user 104.

Hearing instruments 102 may comprise one or more of various types of devices that are configured to provide auditory stimuli to user 104 and that are designed for wear and/or implantation at, on, or near an ear of user 104. Hearing instruments 102 may be worn, at least partially, in the ear canal or concha. One or more of hearing instruments 102 may include behind the ear (BTE) components that are worn behind the ears of user 104. In some examples, hearing instruments 102 comprise devices that are at least partially implanted into or integrated with the skull of user 104. In some examples, one or more of hearing instruments 102 provide auditory stimuli to user 104 via a bone conduction pathway.

In any of the examples of this disclosure, each of hearing instruments 102 may comprise a hearing assistance device. Hearing assistance devices include devices that help a user hear sounds in the user's environment. Example types of hearing assistance devices may include hearing aid devices, Personal Sound Amplification Products (PSAPs), cochlear implant systems (which may include cochlear implant magnets, cochlear implant transducers, and cochlear implant processors), and so on. In some examples, hearing instruments 102 are over-the-counter, direct-to-consumer, or prescription devices. Furthermore, in some examples, hearing instruments 102 include devices that provide auditory stimuli to user 104 that correspond to artificial sounds or sounds that are not naturally in the environment of user 104, such as recorded music, computer-generated sounds, or other types of sounds. For instance, hearing instruments 102 may include so-called "hearables," earbuds, earphones, or other types of devices. Some types of hearing instruments provide auditory stimuli to user 104 corresponding to sounds from the environment of user 104 and also artificial sounds.

In some examples, one or more of hearing instruments 102 may be In-The-Ear (ITE) devices, which include a housing worn within the concha and cymba concha. In some examples, one or more of hearing instruments 102 may be In-The-Canal (ITC) devices, which include a housing worn primarily within the concha. In some examples, one or more of hearing instruments 102 may be Completely-In-Canal (CIC) devices, which include a housing worn primarily within an external portion of the auditory canal. In ITE, ITC, and CIC hearing instruments, a receiver that generates sound is included within the housing of the hearing instruments.

Hearing instruments 102 may implement a variety of features that help user 104 hear better. For example, hearing instruments 102 may amplify the intensity of incoming sound, amplify the intensity of certain frequencies of the incoming sound, attenuate certain frequencies, and/or translate or compress frequencies of the incoming sound. In another example, hearing instruments 102 may implement a directional processing mode in which hearing instruments 102 selectively amplify sound originating from a particular direction (e.g., to the front of the user) while potentially fully or partially canceling sound originating from other directions. In other words, a directional processing mode may selectively attenuate off-axis unwanted sounds. The directional processing mode may help users understand conversations occurring in crowds or other noisy environments. In some examples, hearing instruments 102 may use beamforming or directional processing cues to implement or augment directional processing modes.

In some examples, hearing instruments 102 may reduce noise by canceling out or attenuating certain frequencies. Furthermore, in some examples, hearing instruments 102 may help user 104 enjoy audio media, such as music or sound components of visual media, by outputting sound based on audio data wirelessly transmitted to hearing instruments 102.

Hearing instruments 102 may be configured to communicate with each other. For instance, in any of the examples of this disclosure, hearing instruments 102 may communicate with each other using one or more wireless communication technologies. Example types of wireless communication technology include Near-Field Magnetic Induction (NFMI) technology, a 2.4 GHz technology, a BLUETOOTH^{™} technology, a WI-FI ^{™} technology, audible sound signals, ultrasonic communication technology, infrared communication technology, an inductive communication technology, or another type of communication that does not rely on wires to transmit signals between devices. In some examples, hearing instruments 102 use a 2.4 GHz frequency band for wireless communication.

As shown in the example of FIG. 1, system 100 may also include a computing device 106. In other examples, system 100 does not include computing device 106. Computing device 106 may comprise one or more mobile devices, server devices, personal computer devices, handheld devices, wireless access points, smart speaker devices, smart televisions, medical alarm devices, smart key fobs, smartwatches, smartphones, motion or presence sensor devices, smart displays, screen-enhanced smart speakers, wireless routers, wireless communication hubs, prosthetic devices, mobility devices, special-purpose devices, accessory devices, and/or other types of devices. Accessory devices (not shown in FIG. 1) may include devices that are configured specifically for use with hearing instruments 102. Example types of accessory devices may include charging cases for hearing instruments 102, storage cases for hearing instruments 102, media streamer devices, phone streamer devices, external microphone devices, remote controls for hearing instruments 102, and other types of devices specifically designed for use with hearing instruments 102. One or more of hearing instruments 102 may communicate with computing device 106 using wireless or non-wireless communication links. For instance, hearing instruments 102 may communicate with computing device 106 and/or each other using any of the example types of communication technologies described elsewhere in this disclosure. For example, hearing instruments 102 may communicate with computing device 106 and/or each other using antennas conforming to the antenna designs described in this disclosure.

In the example of FIG. 1, hearing instrument 102A includes an antenna 110A and hearing instrument 102B includes an antenna 110B. This disclosure may refer to antenna 110A and antenna 110B collectively as "antennas 110." As described in greater detail below, antenna 110A may include at least a first antenna segment and a second antenna segment. The first antenna segment is between a feed point of antenna 110A and the second antenna segment. The first antenna segment provides an in-line filter that is configured to attenuate one or more harmonic frequencies from an electrical current passing between the feed point and the second antenna segment via the first antenna segment. Antenna 110B may be implemented in the same way as antenna 110A. In some examples, antenna efficiencies at some harmonics are degraded significantly in-air or in free-space due to increased mismatch-loss and/or impedance mismatch. In some examples, the in-line filter may allow improved in-situ antenna impedance matching at the fundamental frequency.

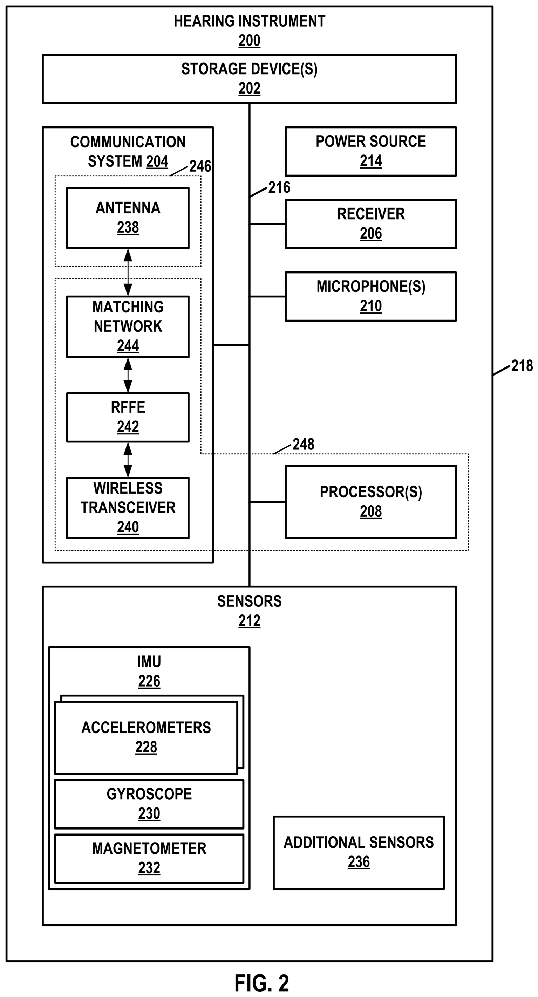

FIG. 2 is a block diagram illustrating example components of a hearing instrument 200, in accordance with one or more aspects of this disclosure. Hearing instrument 200 may be either one of hearing instruments 102. Each of hearing instruments 102 may include the same components as hearing instrument 200.

In the example of FIG. 2, hearing instrument 200 comprises one or more storage devices 202, a communication system 204, a receiver 206, one or more processors 208, one or more microphones 210, a set of sensors 212, a power source 214, and one or more communication channels 216. Communication channels 216 provide communication between storage devices 202, communication system 204, receiver 206, processors 208, one or more microphones 210, and sensors 212. Storage devices 202, communication system 204, receiver 206, processors 208, microphones 210, and sensors 212 may draw electrical power from power source 214. In the example of FIG. 2, each of storage devices 202, communication system 204, receiver 206, processors 208, microphones 210, and sensors 212, power source 214, and communication channels 216 may be contained within a single housing 218.

Furthermore, in the example of FIG. 2, sensors 212 include an inertial measurement unit (IMU) 226 that is configured to generate data regarding the motion of hearing instrument 200. IMU 226 may include a set of sensors. For instance, in the example of FIG. 2, IMU 226 includes one or more accelerometers 228, a gyroscope 230, a magnetometer 232, combinations thereof, and/or other sensors for determining the motion of hearing instrument 200. Furthermore, in the example of FIG. 2, hearing instrument 200 may include one or more additional sensors 236. Additional sensors 236 may include a photoplethysmography (PPG) sensor, blood oximetry sensors, blood pressure sensors, electrocardiograph (EKG) sensors, body temperature sensors, electroencephalography (EEG) sensors, environmental temperature sensors, environmental pressure sensors, environmental humidity sensors, skin galvanic response sensors, and/or other types of sensors. In other examples, hearing instrument 200 and sensors 212 may include more, fewer, or different components.

Storage devices 202 may store data. Storage devices 202 may comprise volatile memory and may therefore not retain stored contents if powered off. Examples of volatile memories may include random access memories (RAM), dynamic random access memories (DRAM), static random access memories (SRAM), and other forms of volatile memories known in the art. Storage devices 202 may further be configured for long-term storage of information as non-volatile memory space and retain information after power on/off cycles. Examples of non-volatile memory configurations may include magnetic hard discs, optical discs, floppy discs, flash memories, or forms of electrically programmable memories (EPROM) or electrically erasable and programmable (EEPROM) memories.

Communication system 204 may enable hearing instrument 200 to send data to and receive data from one or more other devices, such as another hearing instrument, an accessory device, a mobile device, or another type of device. Communication system 204 may enable hearing instrument 200 to communicate using wireless communication technologies. For instance, communication system 204 may enable hearing instrument 200 to communicate using one or more of various types of wireless technology, such as a BLUETOOTH^{™} technology, 3G, 4G, 4G Long Term Evolution (LTE), 5G, ZigBee, WI-FI^{™}, Near-Field Magnetic Induction (NFMI), ultrasonic communication, infrared (IR) communication, or another wireless communication technology.

As shown in the example of FIG. 2, communication system 204 includes an antenna 238 and a wireless transceiver 240. Antenna 238 may correspond to antenna 110A or 110B in FIG. 1. Wireless transceiver 240 may comprise circuitry configured to generate modulated electrical signals sent to antenna 238 and/or to process electrical signals received from antenna 238. In some examples, such as the example of FIG. 2, communication system 204 may include an RFFE 242. RFFE 242 may include one or more components that process signals from antenna 238 and/or wireless transceiver 240. For instance, RFFE 242 may include an amplifier that amplifies the signals. In some examples, RFFE 242 may include components that implement one or more filters, such as band-pass filters. In other examples, communication system 204 does not include RFFE 242.

Additionally, in some examples, such as the example of FIG. 2, communication system 204 may include a matching network 244. Matching network 244 may be configured to perform impedance matching. In other words, matching network 244 may adjust the input impedance of antenna 238 and/or the output impedance of RFFE 242.

Antenna 238 may be implemented in accordance with any of the example antenna designs described in this disclosure. For instance, antenna 238 may include at least a first antenna segment and a second antenna segment. The first antenna segment is between a feed point of antenna 238 and the second antenna segment. The first antenna segment provides an in-line filter that is configured to attenuate one or more harmonic frequencies from an electrical current passing between the feed point and the second antenna segment via the first antenna segment. The harmonic frequencies are integer multiples of a fundamental frequency. Both the first antenna segment and the second antenna segment may be radiating elements of antenna 238. For instance, both the first antenna segment and the second antenna segment may be driven elements. As mentioned above, RFFE 242 may include one or more filters. Thus, antenna 238, with its in-line filter, may work in conjunction with existing filtering to enable passing radio regulatory emission limits and to provide design margin that should minimize the need for last-minute design changes to pass radio regulations.

Receiver 206 comprises one or more speakers for generating audible sound. Microphones 210 detect incoming sound and generate one or more electrical signals (e.g., an analog or digital electrical signal) representing the incoming sound.

Processors 208 may be processing circuits configured to perform various activities. For example, processors 208 may process the signal generated by microphones 210 to enhance, amplify, or cancel-out particular channels within the incoming sound. Processors 208 may then cause receiver 206 to generate sound based on the processed signal. In some examples, processors 208 include one or more digital signal processors (DSPs). In some examples, processors 208 may cause communication system 204 to transmit one or more of various types of data. For example, processors 208 may cause communication system 204 to transmit data to computing device 106. In some examples, processors 208 may cause communication system 204 to transmit data to another hearing instrument. Furthermore, communication system 204 may receive audio data from computing device 106 and processors 208 may cause receiver 206 to output sound based on the audio data.

In the example of FIG. 2, antenna 238 may be (or may be on) an antenna flex 246. Thus, a single flexible conductor comprises at least both the first antenna segment and the second antenna segment. In some examples, one or more flexible conductors comprise the first antenna segment and the second antenna segment. Antenna flex 246 may be a flexible conductor for transmitting or receiving RF signals. In some examples, antenna flex 246 is a 2-layer flexible circuit. One or more of matching network 244, RFFE 242, wireless transceiver 240, processors 208, and/or other components of hearing instrument 200 may be on one or more main flex circuits 248 (i.e., flexible circuit boards). In some examples, main flex circuits 248 may be 4-layer flexible circuits. Including the in-line filter in a segment of antenna 238, which is in antenna flex 246, may allow smaller physical implementations and also faster iterations, as the typical 2-layer antenna flex can be modified and fabricated much more quickly than a 4-layer main flex.

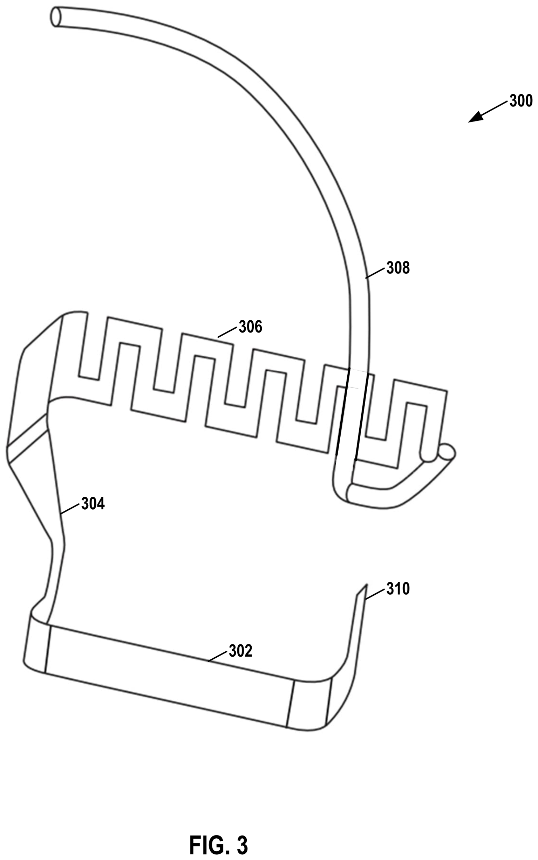

FIG. 3 is a schematic diagram illustrating an example baseline antenna 300, in accordance with one or more aspects of this disclosure. In the example of FIG. 3, antenna 300 includes a first antenna segment 302, a second antenna segment 304, a third antenna segment 306, and a fourth antenna segment 308. A feed point 310 is located at an opposite end of antenna 300 from fourth antenna segment 308. Thus, first antenna segment 302 is positioned between feed point 310 and second antenna segment 304.

Antenna 300 may be suitable for inclusion in an ITC hearing instrument, a CIC hearing instrument, or another type of hearing instrument. In some examples, fourth antenna segment 308 is included in a removal handle of the hearing instrument.

In the example of FIG. 3, an L-section matching network at the antenna feed point with two passive components may be used for matching at the fundamental frequency. The passive components may include an inductor and a capacitor.

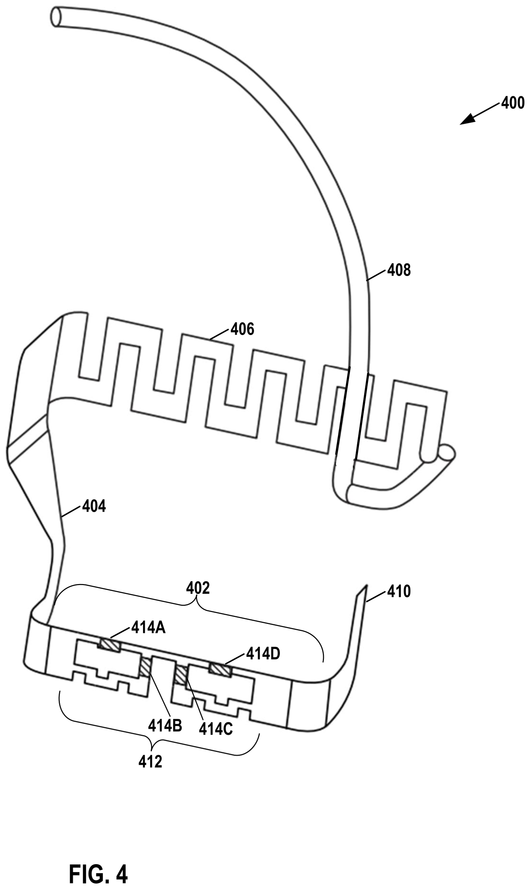

FIG. 4 is a schematic diagram illustrating an example antenna 400 with an in-line filter 412, in accordance with one or more aspects of this disclosure. Antenna 400 may have the same size and shape as antenna 300 except that antenna 400 provides in-line filter 412. Thus, antenna 400 includes a first antenna segment 402, a second antenna segment 404, a third antenna segment 406, and a fourth antenna segment 408. Each of first antenna segment 402, second antenna segment 404, third antenna segment 406, and fourth antenna segment 408 may be antenna elements configured to emit and receive RF radiation. A feed point 410 is located at an opposite end of antenna 400 from fourth antenna segment 408. Thus, first antenna segment 402 is positioned between feed point 410 and second antenna segment 404.

First antenna segment 402 provides in-line filter 412. In-line filter 412 is configured to attenuate one or more harmonic frequencies from an electrical current passing between feed point 410 and second antenna segment 404 (and other antenna segments) via first antenna segment 402.

In contrast to antenna 300 of FIG. 3, which may require an L-section matching network at the feed point, antenna 400 may require a lesser number of components for matching at the feed point, since the in-line filter may help the fundamental matching while suppressing one or more harmonics. In-line filter 412 includes one or more filter elements 414A-414D (collectively, "filter elements 414"). Filter elements 414 may be implemented as inductors, capacitors, or other types of electronic components. For example, components may contain printed and interdigitated capacitors, and spiral inductors or meandered lines, also included in the example of FIG. 4. Filter elements 414 may contain discrete RF (chip) components, or distributed RF elements, or combinations of both. A distributed RF element is a component in an RF circuit where physical dimensions are comparable to a half-wavelength or less of signals being processed. Furthermore, in a different use case one or more of the four filter elements 414 can be replaced with distributed components like meandered lines or interdigitated capacitors.

In the example of FIG. 4, in-line filter 412 includes four filter elements 414. In other examples, in-line filter 412 may include fewer than four filter elements 414. In some examples, in-line filter 412 does not include any discrete filter elements 414. In such examples, the shape of antenna segment 402 alone may sufficiently attenuate one or more harmonics. In some examples, the shape of the antenna segment alone sufficiently attenuates one or more harmonics without requiring discrete filter elements. The in-line filter may comprise distributed RF elements having physical dimensions comparable to a half-wavelength or less of the processed signals. For instance, the antenna segment may utilize meandered lines or conductors having alternating indentations to introduce specific amounts of inductance into the in-line filter. Additionally, or alternatively, the in-line filter may utilize stepped impedance transmission lines to mimic the function of a parallel resonant LC trap. A high impedance thin series conductor may provide series inductance, while a low impedance wide series conductor may provide shunt capacitance. Furthermore, the in-line filter may employ RF resonators, such as split ring resonators or printed interdigitated capacitors, integrated directly into the conductive structure of the antenna segment.

Different numbers of filter elements 414 may be used to ensure sufficient attenuation of the one or more harmonics in different hearing instruments. Adding or removing filter elements 414 from a design of antenna 400 may be relatively easy without changing the size or shape of the second, third or fourth antenna segments 404, 406 and 408. It may therefore be easier to change the design of antenna 400 by adding or removing filter elements to ensure that antenna 400 complies with RF emissions regulations, even late in a design process.

One or more of filter elements 414 may be tunable. Tuning allows for an increased reduction of antenna harmonic radiation at one or more select harmonics. For example, a parallel resonant in-line inductor-capacitor (LC) "trap" may be tuned to resonance at a particular harmonic number of interest, to notch-out that particular (troublesome) harmonic. For instance, a trap may include an inductor and a capacitor in parallel. The inductor may include a length of wire wrapped around a core. The LC trap serves to block signals at chosen frequencies such as the one or more harmonics. Tuning the LC trap may involve adjusting the spacing of turns of the wire around the core, or selecting a chip component with a different inductance value for the design. Alternatively, the LC trap may be tuned by changing the value of the capacitor. A parallel resonant in-line LC trap could be tuned to resonate at a particular harmonic number of interest, to notch-out that particular (troublesome) harmonic. Tuning the LC traps may allow additional flexibility for reducing last-minute changes to the antenna and flex printed circuit board (PCB) to pass radio regulatory limits, which are typically tested with production-level devices near the end of the project. In the example of FIG. 4, filter element 414A may be an inductor and filter element 414B may be a capacitor (or vice versa), thereby forming a first LC trap. Similarly, filter element 414D may be an inductor and filter element 414C may be a capacitor (or vice versa), thereby forming a second LC trap. In other examples, in-line filter 412 includes a single LC trap (e.g., by excluding filter element 414A or filter element 414B; or by excluding filter element 414C or filter element 414D). In other examples, in-line filter 414 may include more than two such LC traps (e.g., by including another set of arms and filter elements).

In-line filter 412 is provided not to include any connection to ground because the ground is unavailable. So, rather than a traditional low pass or bandpass design, an in-line parallel resonant trap having a high series impedance is used to restrict current flow to the antenna at harmonic frequencies. The parallel inductor L-capacitor (LC) trap function can be achieved by other distributed element structures, a combination of lumped and distributed elements, or RF resonators (e.g., split ring resonator, short segments of stepped impedance transmission lines like high impedance thin series conductor for series inductance and low impedance wide series conductor for shunt capacitance) mimicking the function of a LC trap.

In some examples, antenna 400 is compartmentalized into two serial interconnected portions: an interior antenna portion which contains an in-line filter in accordance with one or more techniques of this disclosure (e.g., antenna segments 402, 404, and 406), connecting to the second portion which is an exterior antenna portion (possibly a removal handle antenna, e.g., antenna segment 408). In this way, the interior portion may be used in place of an alternate interior portion without the in-line filter, typically if harmonic radiation is an issue with the initial alternate interior portion. Thus, antenna 400 may comprise an internal portion and an external portion, the internal portion being configured to be positioned within a housing of the hearing instrument and the external portion being configured to be external to the housing of the hearing instrument. In this way, neither the exterior antenna portion, nor the main flex printed circuit board assembly may need to be modified to enable increased harmonic filtering.

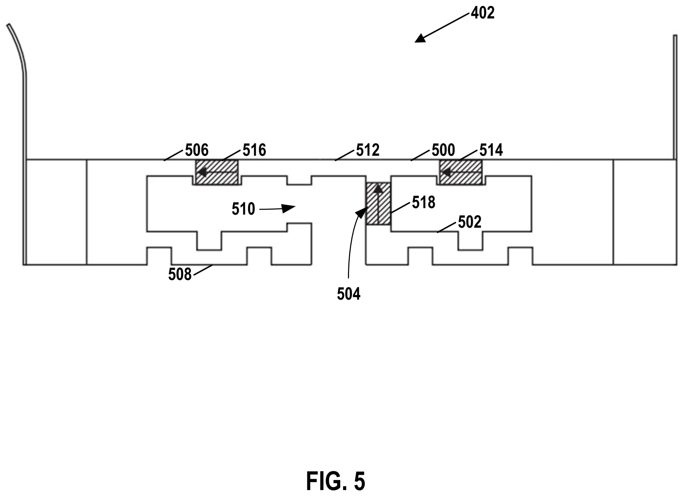

FIG. 5 is a schematic diagram illustrating example details of antenna segment 402 that provides in-line filter 412, in accordance with one or more aspects of this disclosure. Antenna segment 402 includes one or more filter elements. As shown in the example of FIG. 5, antenna segment 402 includes a first branch 500 and a second branch 502 separated by a first conductor opening 504. Additionally, antenna segment 402 includes a third branch 506 and a fourth branch 508 separated by a second conductor opening 510. A neck 512 connects first branch 500 and third branch 506. In the example of FIG. 5, a filter element 514 is disposed on first branch 500. A filter element 516 is disposed on third branch 506. A filter element 518 bridges conductor opening 504. Although not shown in the example of FIG. 5, an additional filter element may bridge second conductor opening 510, e.g., as shown in the example of FIG. 4. The particular arrangement in the example of filter elements in FIG. 5 may target fourth and fifth harmonic rejection or alternatively any other two harmonics that are chosen, depending on the values of the lumped elements and shape of the distributed conductors. In some examples, in-line filter 412 includes two 3.3nH inductors in series (i.e., filter elements 514 and 516) and one 0.5pF capacitor (i.e., filter element 518).

In some examples, one or more of first branch 500, second branch 502, third branch 506, and fourth branch 508 are meandered. In other words, one or more of first branch 500, second branch 502, third branch 506, and fourth branch 508 may have alternating indentations, and therefore have a winding or indirect course. The meandering may introduce inductance into in-line filter 412. Different amounts of meandering may introduce different amounts of inductance, which may attenuate one or more harmonics to different degrees.

The following clauses describe example techniques of this disclosure.

Clause 1. An antenna for a hearing instrument, the antenna comprising: a first antenna segment; and a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

Clause 2. The antenna of clause 1, wherein the in-line filter comprises one or more filter elements.

Clause 3. The antenna of clause 2, wherein the first antenna segment comprises: a first branch and a second branch separated by a first conductor opening; a third branch and a fourth branch separated by a second conductor opening; and a neck that connects the first branch and the third branch, and wherein at least one of: a filter element of the one or more filter elements is disposed on the first branch, a filter element of the one or more filter elements is disposed on the third branch, a filter element of the one or more filter elements bridges the first conductor opening, or a filter element of the one or more filter elements bridges the second conductor opening.

Clause 4. The antenna of clause 3, wherein the second branch and the fourth branch are meandered.

Clause 5. The antenna of any of clauses 3-4, wherein a filter element of the one or more filter elements bridges the first conductor opening.

Clause 6. The antenna of any of clauses 3-5, wherein the one or more filter elements includes at least a first filter element and a second filter element, the first filter element bridging the first conductor opening and the second filter element bridging the second conductor opening.

Clause 7. The antenna of any of clauses 3-6, wherein the one or more filter elements includes at least one of: a filter element disposed on the first branch, or a filter element disposed on the third branch.

Clause 8. The antenna of any of clauses 1-7, wherein the in-line filter comprises one or more LC traps.

Clause 9. The antenna of any of clauses 1-8, wherein one or more flexible conductors comprise the first antenna segment and the second antenna segment.

Clause 10. The antenna of any of clauses 1-9, wherein the antenna comprises an internal portion and an external portion, the internal portion being configured to be positioned within a housing of the hearing instrument and the external portion being configured to be external to the housing of the hearing instrument.

Clause 11. A hearing instrument comprising an antenna that comprises: a first antenna segment; and a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

Clause 12. The hearing instrument of clause 11, wherein the in-line filter comprises one or more filter elements.

Clause 13. The hearing instrument of clause 12, wherein the first antenna segment comprises: a first branch and a second branch separated by a first conductor opening; a third branch and a fourth branch separated by a second conductor opening; and a neck that connects the first branch and the third branch, and wherein at least one of: a filter element of the one or more filter elements is disposed on the first branch, a filter element of the one or more filter elements is disposed on the third branch, a filter element of the one or more filter elements bridges the first conductor opening, or a filter element of the one or more filter elements bridges the second conductor opening.

Clause 14. The hearing instrument of clause 13, wherein the second branch and the fourth branch are meandered.

Clause 15. The hearing instrument of any of clauses 13-14, wherein a filter element of the one or more filter elements bridges the first conductor opening.

Clause 16. The hearing instrument of any of clauses 13-15, wherein a filter element of the one or more filter elements bridges the second conductor opening.

Clause 17. The hearing instrument of any of clauses 13-16, wherein the one or more filter elements includes at least a first filter element and a second filter element, the first filter element bridging the first conductor opening and the second filter element bridging the second conductor opening.

Clause 18. The hearing instrument of any of clauses 13-17, wherein the one or more filter elements includes at least one of: a filter element disposed on the first branch, or a filter element disposed on the third branch.

Clause 19. The hearing instrument of any of clauses 11-18, wherein one or more flexible conductors comprise the first antenna segment and the second antenna segment.

Clause 20. The hearing instrument of any of clauses 11-19, wherein the hearing instrument comprises a housing, and the antenna comprises an internal portion and an external portion, the internal portion being configured to be positioned within the housing and the external portion being configured to be external to the housing of the hearing instrument.

In this disclosure, ordinal terms such as "first," "second," "third," and so on, are not necessarily indicators of positions within an order, but rather may be used to distinguish different instances of the same thing. Examples provided in this disclosure may be used together, separately, or in various combinations.

It is to be recognized that depending on the example, certain acts or events of any of the features or techniques described herein can be created, assembled, or performed in a different sequence, may be added, merged, or left out altogether (e.g., not all described acts or events are necessary for the practice of the techniques). For instance, this disclosure describes various examples of an antenna, these examples may be used individually or in combination. Moreover, in certain examples, acts or events may be performed concurrently, e.g., through multi-threaded processing, interrupt processing, or multiple processors, rather than sequentially.

In one or more examples, the functions described may be implemented in hardware, software, firmware, or any combination thereof. If implemented in software, the functions may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave. Data storage media may be any available media that can be accessed by one or more computers or one or more processing circuits to retrieve instructions, code and/or data structures for implementation of the techniques described in this disclosure. A computer program product may include a computer-readable medium.

By way of example, and not limitation, such computer-readable storage media can comprise RAM, ROM, EEPROM, CD-ROM or other optical disk storage, magnetic disk storage, or other magnetic storage devices, flash memory, cache memory, or any other medium that can be used to store desired program code in the form of instructions or data structures and that can be accessed by a computer. Also, any connection is properly termed a computer-readable medium. For example, if instructions are transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. It should be understood, however, that computer-readable storage media and data storage media do not include connections, carrier waves, signals, or other transient media, but are instead directed to non-transient, tangible storage media. Disk and disc, as used herein, includes compact disc (CD), laser disc, optical disc, digital versatile disc (DVD), floppy disk and Blu-ray disc, where disks usually reproduce data magnetically, while discs reproduce data optically with lasers. Combinations of the above should also be included within the scope of computer-readable media.

Functionality described in this disclosure may be performed by fixed function and/or programmable processing circuitry. For instance, instructions may be executed by fixed function and/or programmable processing circuitry. Such processing circuitry may include one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules. Also, the techniques could be fully implemented in one or more circuits or logic elements. Processing circuits may be coupled to other components in various ways. For example, a processing circuit may be coupled to other components via an internal device interconnect, a wired or wireless network connection, or another communication medium.

Where a phrase similar to "one or more processors configured to X, Y, and Z" is used in the claims, it is intended that the phrase be interpreted to mean at least: that a processor A alone may perform functions X, Y, and Z; that two or more processors (e.g., processors A and B) may collectively perform functions X, Y, and Z; that a first processor A may perform functions X and Y and a second processor may perform function Z; or that a first processor A may perform function X, a second processor may perform function Y, and a third processor may perform function Z.

The techniques of this disclosure may be implemented in a wide variety of devices or apparatuses. Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

The following aspects are preferred additional or alternative embodiments of the present disclosure:
1. An antenna for a hearing instrument, the antenna comprising:
   a first antenna segment; and
   a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.
2. The antenna of aspect 1, wherein the in-line filter comprises one or more filter elements.
3. The antenna of aspect 2, wherein the first antenna segment comprises:
   a first branch and a second branch separated by a first conductor opening;
   a third branch and a fourth branch separated by a second conductor opening; and
   a neck that connects the first branch and the third branch, and
   wherein at least one of:
      a filter element of the one or more filter elements is disposed on the first branch,
      a filter element of the one or more filter elements is disposed on the third branch,
      a filter element of the one or more filter elements bridges the first conductor opening, or
      a filter element of the one or more filter elements bridges the second conductor opening.
4. The antenna of aspect 3, wherein the second branch and the fourth branch are meandered.
5. The antenna of any one of aspects 3-4, wherein a filter element of the one or more filter elements bridges the first conductor opening.
6. The antenna of any one of aspects 3-5, wherein the one or more filter elements includes at least a first filter element and a second filter element, the first filter element bridging the first conductor opening and the second filter element bridging the second conductor opening.
7. The antenna of any one of aspects 3-6, wherein the one or more filter elements includes at least one of:
   a filter element disposed on the first branch, or
   a filter element disposed on the third branch.
8. The antenna of any one of aspects 1-7, wherein the in-line filter comprises one or more LC traps.
9. The antenna of any one of aspects 1-8, wherein one or more flexible conductors comprise the first antenna segment and the second antenna segment.
10. The antenna of any one of aspects 1-9, wherein the antenna comprises an internal portion and an external portion, the internal portion being configured to be positioned within a housing of the hearing instrument and the external portion being configured to be external to the housing of the hearing instrument.
11. A hearing instrument comprising an antenna that comprises:
   a first antenna segment; and
   a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.
12. The hearing instrument of aspect 11, wherein the in-line filter comprises one or more filter elements.
13. The hearing instrument of aspect 12, wherein the first antenna segment comprises:
   a first branch and a second branch separated by a first conductor opening;
   a third branch and a fourth branch separated by a second conductor opening; and
   a neck that connects the first branch and the third branch, and
   wherein at least one of:
      a filter element of the one or more filter elements is disposed on the first branch,
      a filter element of the one or more filter elements is disposed on the third branch,
      a filter element of the one or more filter elements bridges the first conductor opening, or
      a filter element of the one or more filter elements bridges the second conductor opening.
14. The hearing instrument of aspect 13, wherein the second branch and the fourth branch are meandered.
15. The hearing instrument of any one of aspects 13-14, wherein a filter element of the one or more filter elements bridges the first conductor opening.
16. The hearing instrument of any one of aspects 13-15, wherein a filter element of the one or more filter elements bridges the second conductor opening.
17. The hearing instrument of any one of aspects 13-16, wherein the one or more filter elements includes at least a first filter element and a second filter element, the first filter element bridging the first conductor opening and the second filter element bridging the second conductor opening.
18. The hearing instrument of any one of aspects 13-17, wherein the one or more filter elements includes at least one of:
   a filter element disposed on the first branch, or
   a filter element disposed on the third branch.
19. The hearing instrument of any one of aspects 11-18, wherein one or more flexible conductors comprise the first antenna segment and the second antenna segment.
20. The hearing instrument of any one of aspects 11-19, wherein the hearing instrument comprises a housing, and the antenna comprises an internal portion and an external portion, the internal portion being configured to be positioned within the housing and the external portion being configured to be external to the housing of the hearing instrument.

## Claims

1. An antenna for a hearing instrument, the antenna comprising:
a first antenna segment; and
a second antenna segment, wherein the first antenna segment is between a feed point of the antenna and the second antenna segment, the first antenna segment provides an in-line filter that is configured to attenuate one or more harmonic frequencies from an electrical current passing between the feed point and the second antenna segment via the first antenna segment.

2. The antenna of claim 1, wherein the in-line filter comprises one or more filter elements.

3. The antenna of claim 2, wherein the first antenna segment comprises:
a first branch and a second branch separated by a first conductor opening;
a third branch and a fourth branch separated by a second conductor opening; and
a neck that connects the first branch and the third branch, and
wherein at least one of:
a filter element of the one or more filter elements is disposed on the first branch,
a filter element of the one or more filter elements is disposed on the third branch,
a filter element of the one or more filter elements bridges the first conductor opening, or
a filter element of the one or more filter elements bridges the second conductor opening.

4. The antenna of claim 3, wherein the second branch and the fourth branch are meandered.

5. The antenna of any of claims 3-4, wherein a filter element of the one or more filter elements bridges the first conductor opening.

6. The antenna of any of claim 3-5, wherein the one or more filter elements includes at least a first filter element and a second filter element, the first filter element bridging the first conductor opening and the second filter element bridging the second conductor opening.

7. The antenna of any of claims 3-6, wherein the one or more filter elements includes at least one of:
a filter element disposed on the first branch, or
a filter element disposed on the third branch.

8. The antenna of any of claims 1-7, wherein the in-line filter comprises one or more LC traps.

9. The antenna of any of claims 1-8, wherein one or more flexible conductors comprise the first antenna segment and the second antenna segment.

10. The antenna of any of claims 1-9, wherein the antenna comprises an internal portion and an external portion, the internal portion being configured to be positioned within a housing of the hearing instrument and the external portion being configured to be external to the housing of the hearing instrument.

11. A hearing instrument comprising an antenna as described in any of claims 1-10.
